Europäisches Patentamt

European Patent Office

Office européen des brevets

(19)

(11) Publication number: **0 014 098**
**B1**

(12) **EUROPEAN PATENT SPECIFICATION**

(45) Date of publication of patent specification: **18.04.84**

(21) Application number: **80300211.2**

(22) Date of filing: **23.01.80**

(51) Int. Cl.³: **H 01 L 29/743,**
**H 01 L 29/08**

(54) Gate turn-off thyristor.

(30) Priority: **24.01.79 JP 6067/79**

(43) Date of publication of application:
**06.08.80 Bulletin 80/16**

(45) Publication of the grant of the patent:
**18.04.84 Bulletin 84/16**

(84) Designated Contracting States:
**DE GB NL SE**

(56) References cited:
**DE - A - 1 935 164**
**DE - A - 2 906 721**
**FR - A - 2 341 204**
**US - A - 3 239 728**
**US - A - 3 590 346**

**IEEE TRANSACTIONS ON ELECTRON DEVICES,**
**vol. ED-17, no. 9, September 1970, page 816**
**New York, U.S.A. T. MATSUZAWA et al.: "Some**
**Electrical Characteristics of a Reverse**
**Conducting Thyristor"**

(73) Proprietor: **Hitachi, Ltd.**
**5-1, Marunouchi 1-chome**
**Chiyoda-ku Tokyo 100 (JP)**

(72) Inventor: **Yatsuo, Tsutomu**
**28-7 Mizukicho 2-chome**
**Hitachi-shi (JP)**
Inventor: **Nagano, Takahiro**
**2693-5 Kanesawacho**
**Hitachi-shi (JP)**

(74) Representative: **Paget, Hugh Charles Edward et al,**
**MEWBURN ELLIS & CO. 2/3 Cursitor Street**
**London EC4A 1BQ (GB)**

## Gate turn-off thyristor

The present invention relates to a gate turn-off thyristor, and more particularly to a gate turn-off thyristor suitable for control of an inductive load of high power.

A gate turn-off thyristor (hereinafter referred to as a GTO) can be turned from a conductive state into a non-conductive state by applying a gate signal of negative polarity between the gate and the cathode of the thyristor, and therefore can interrupt a large current without employing any commutating circuit. Accordingly, in recent years there has been a serious demand for development of a highly-advanced gate turn-off thyristor. In conventional gate turn-off thyristors, the semiconductor substrate has usually been doped with gold or the like serving as a lifetime killer in order to improve the turn-off characteristics. When the substrate is doped with a large amount of gold such characteristics as turn-off gain and turn-off time can be greatly improved, but the turn-on voltage becomes high and moreover the leakage current at high temperatures is increased so that the blocking characteristic is poor. Thus, conventional GTO's are not suitable to control high power and cannot withstand a high applied voltage.

In recent years, there has been developed a GTO having a structure in which an emitter-base junction on the anode side is appropriately short-circuited to permit turn-off operation in a few microseconds without the substrate containing gold as described above. Thus, it has become possible to provide a GTO having a low loss which is capable of wide use as a high-power chopper or inverter in various fields such as a control unit of a large-scale motor and power circuits.

An example of such a shorted emitter GTO is disclosed in US—A—3,239,728. The GTO has first to fourth semiconductor regions in a layered configuration with adjacent regions having different conductivity types, the two outer regions (first and fourth regions) are respectively in ohmic contact with first and second electrodes and one of the inner regions is contacted by a control electrode. In one of the GTOs disclosed in US—A—3,239,728, the outer layer not adjacent the inner region contacted by the control electrode (the first region) is formed as a series of projections which are surrounded by conductive material of the first electrode so that the first electrode contacts the inner layer (the second region) adjacent the first region to short circuit the first and second regions.

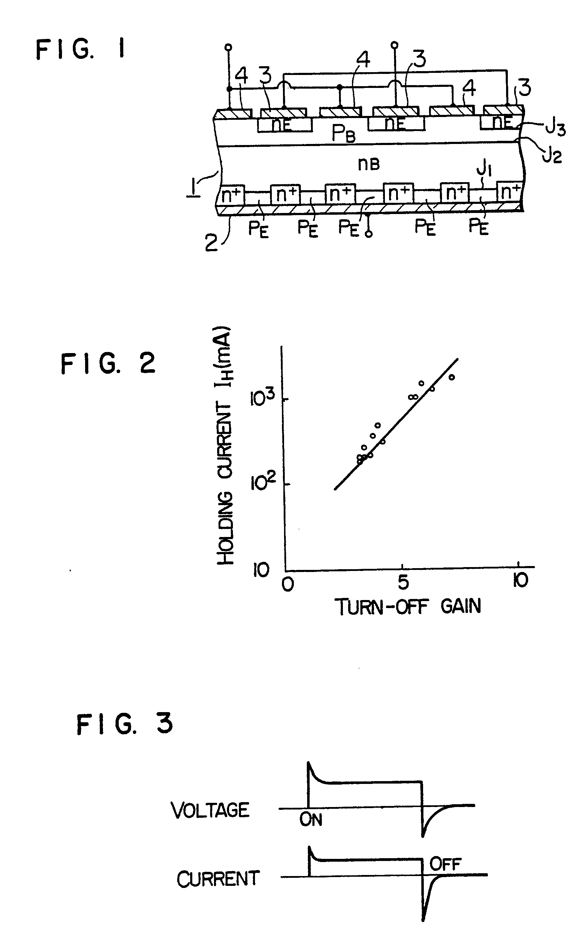

The applicants have developed the shorted emitter GTO. Fig. 1 of the accompanying drawings is a cross section of one of the applicants GTOs in which the emitter-base junction on the anode side is short-circuited. Referring to Fig. 1, a silicon substrate 1 includes a $p_E$ layer, an $n_B$ layer, a $p_B$ layer and an $n_E$ layer, which are stacked to form a p-type emitter base junction $J_1$, a central junction $J_2$ and an n-type emitter-base junction $J_3$.

The p-type emitter-base junction $J_1$ is short-circuited at a plurality of positions by $n^+$ layers penetrating from the principal surface on the anode side into the $n_B$ layer. It is a main feature of this GTO that the projection of the areas of the $n^+$ layers across the thickness of the device falls on the n-type emitter-base junction $J_3$. The surfaces of the $p_E$ and $n^+$ layers, the surface of the $n_E$ layer, and the surface of the $p_B$ layer are in low-resistance contact with an anode electrode 2, a cathode electrode 3, and a gate electrode 4, respectively.

In the conductive state of this GTO, excess carriers which have accumulated in the $n_B$ layer are swept out to the anode electrode 2 through the short-circuited portions of the p-type emitter-base junction $J_1$, i.e. through the $n^+$ layers. Thus, this GTO design has the same effect of extinguishing carriers in the $n_B$ layer as the conventional GTO in which the silicon substrate is doped with gold, and therefore can have an excellent turn-off characteristic. In order to produce such an effect, however, it is required to short-circuit the p-type emitter-base junction $J_1$ at a large number of positions. For example, the junction $J_1$ is short-circuited so as to have a short-circuit resistance of 0.2 to $0.5\Omega$. As a result, the transistor formed by the $p_E$ layer, the $n_B$ layer and the $p_B$ layer has a low current amplification factor $\alpha$, which, the present inventors have now discovered, in practice introduces the following problem. Since in order to improve the turn-off characteristics of the GTO, it is required to short-circuit the p-type emitter-base junction $J_1$ considerably, the gate current required to turn on the GTO is increased, and the minimum load current (or holding current $I_H$) for maintaining the conductive state is also increased.

Fig. 2 shows the relation between the holding current and the turn-off gain, and demonstrates that the turn-off characteristic and the conductive-state maintaining characteristic are mutually contrary.

A GTO which has large gate current $I_{GT}$ and holding current $I_H$, has the disadvantage that when in the conductive state it is readily turned off when supplied for a short time with a current less than the holding current $I_H$, and then remains in the non-conductive state until the next gate signal is applied. Specifically, if the GTO is connected to an inductive load such as an induction motor, the phase difference between the voltage and current applied to the GTO is large and varies in accordance with the state of the load. In order to prevent the GTO in the conductive state from being naturally turned off, a gate signal is applied which has a waveform such that a constant current is superposed on the gate current $I_{GT}$.

Fig. 3 shows the voltage and current waveforms of such a gate signal. When turned on, the GTO is supplied with a gate current of a duration of tens of microseconds, and is thereafter supplied with a constant gate current of several amperes while the GTO is kept in the conductive state, so that the GTO is maintained in the conductive state even if the load current falls below $I_H$. However, when such a gate signal is employed, problems arise such as power loss due to the size of the gate signal, and the gate circuit becomes expensive.

To overcome these problems the present invention proposes forming a fifth semiconductor region, which together with the first second and third regions form an auxiliary thyristor adjacent the main thyristor on a semiconductor element. The turn-on and turn-off signals are applied to a control electrode in low resistance contact with the third semiconductor region. When a suitable signal is applied to the control electrode, the auxiliary thyristor is turned on and the signal is amplified to turn on the main thyristor. Similarly, application of a turn-off signal to the control electrode turns off the main thyristor.

The use of such an auxiliary shorted-emitter thyristor is known in connection with standard thyristors and the resulting configuration has become known as an amplifying gate structure. Examples of such amplifying gate structures are shown in e.g. US—A—3,590,346 and DE—A—1,935,164.

However, a problem arises when an auxiliary thyristor (which cannot be gold doped if the main thyristor is not to be gold doped) is used with a shorted emitter GTO. It has been found by the applicants that the turn-off current in the main GTO sometimes causes the auxiliary thyristor to turn on, thereby preventing turn-off of the main thyristor. The present invention seeks to overcome this problem by

1) providing shorting of the first layer of the main thyristor to the second layer at the boundary of the main thyristor and the auxiliary thyristor, there being no short circuiting of the first layer of the auxiliary thyristor; and

2) providing an auxiliary electrode which surrounds the electrode on the fourth layer and which is disposed in low resistance contact with the third and fifth semiconductor regions to short-circuit those regions, thereby to prevent the auxiliary thyristor turning on during turn-off of the main thyristor.

Embodiments of the invention will now be described by way of example, with reference to the accompanying drawings, in which:—

Figs. 1 to 3 illustrate the applicants shorted emitter GTO and have already been referred to.

Fig. 4 is a fragmentary sectional view of a GTO embodying the present invention.

Fig. 5 is a perspective sectional view of another GTO embodying the present invention.

Fig. 6 is a fragmentary sectional view of a third GTO embodying the present invention.

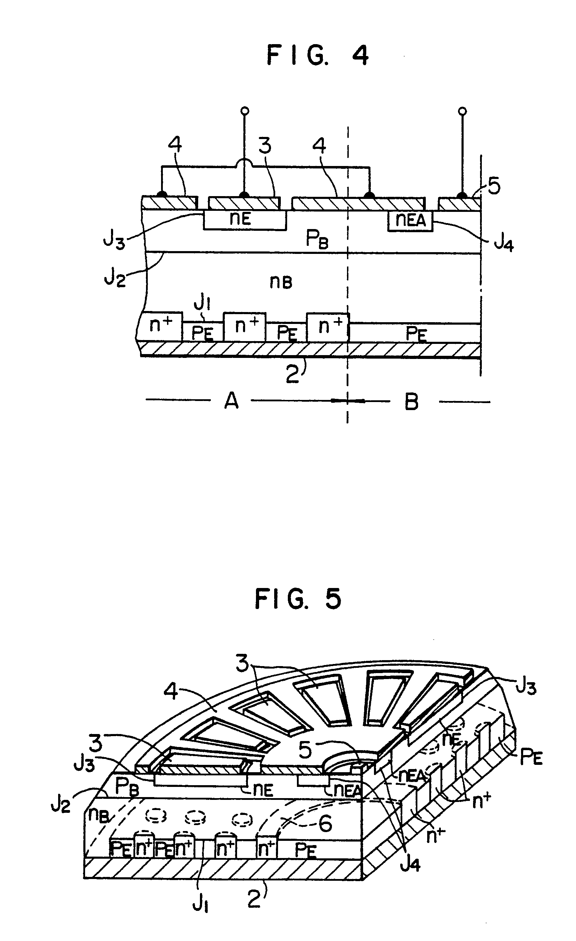

In Figs. 4, 5 and 6, the same reference numerals as used in Fig. 1 designate members identical with or similar to those of Fig. 1.

Referring to Fig. 4, a silicon substrate 1 is divided into A and B regions. In the A region is formed a GTO whose emitter-base junction on the anode side is short-circuited, as in the structure of Fig. 1. In more detail, a plurality of $n^+$ layers, which form a part of an $n_B$ layer, penetrate a $p_E$ layer, and an anode electrode 2 is disposed in low-resistance contact with the surfaces of the $n^+$ and $p_E$ layers. A plurality of $n_E$ layers are exposed to the surface on the cathode side of the substrate, and an n-type emitter-base junction $J_3$ is formed between each of the $n_E$ layers and an adjacent $p_B$ layer. A gate electrode 4 is disposed in low-resistance contact with the surface of the $p_B$ layer with a gap at each of the regularly spaced $n_E$ layers, and a cathode electrode 3 is disposed in low-resistance contact with the surface of each $n_E$ layer. The cathode electrodes 3 are electrically connected to each other. The n-type emitter-base junction $J_3$ is exposed to the surface of the substrate between the gate electrode 4 and the cathode electrode 3.

In the B region there is an auxiliary n-type emitter layer $n_{EA}$ adjacent to the $p_B$ layer. A fourth junction $J_4$, which is another n-type emitter-base junction, is formed between the $n_{EA}$ and $p_B$ layers. The gate electrode 4 is in low-resistance contact with the surfaces of both the $n_{EA}$ and $p_B$ layers. A control electrode 5 is disposed in low-resistance contact with the surface of the $p_B$ layer close to but spaced from the junction $J_4$. In the B region, which includes that portion of the $p_E$ layer on which the projection of the area of the junction $J_4$ across the thickness of the device falls, the $p_E$ layer is not short-circuited. In other words, in the B region, the fourth junction $J_4$ is short-circuited by the gate electrode 4 but the p-type emitter-base junction $J_1$ has no short-circuited portion.

Fig. 5 shows the detailed structure of another embodiment of the present invention, and the dimensions and fabrication of this embodiment will now be explained. A silicon wafer having n-type conductivity and resistivity of 30 to 40Ω. cm is used as a semiconductor substrate. A plurality of $n^+$ layers each having a depth of about 60 $\mu$m are formed on the anode side of the substrate by selective diffusion of phosphorus using an $SiO_2$ film as a mask. The $n^+$ layers have a diameter of 0.07 mm, and are arranged at spacings of 0.3 mm. At the same time, a ring-shaped $n^+$ layer 6 having a width of 0.1 mm is formed so as to encircle a B region having a radius of about 2.5 mm. The ring shaped $n^+$ layer 6 is disposed at the boundary between the main thyristor and the auxiliary thyristor so as to lead carriers in the $n_B$ layer of the auxiliary thyristor to the anode electrode 2 so as to help the auxiliary thyristor turn-off quickly so that the auxiliary thyristor turns-off simultaneously with the main thyristor. Next, gallium is diffused into both surfaces of the substrate to form p-type layers having a depth of about 55 $\mu$m; on the anode side, $p_E$ layers are formed at surface portions other than those which have been subjected to diffusion of phosphorus. Then, selective diffusion of phosphorus is again conducted on the cathode side to form n-type layers having a depth of about 25 $\mu$m in the $p_B$ layer; in particular, a plurality of strip-shaped $n_E$ layers each having a width of about 200 $\mu$m are formed in an A region, and a ring-shaped $n_{EA}$ layer having an inner diameter of 1.0 mm and an outer diameter of 1.5 mm is formed in the B region. Subsequently, the anode side of the substrate is alloyed to a 2.5 mm thick supporting plate made of tungsten through aluminium serving as a solder. The cathode side is coated with an evaporated aluminium film, which is subjected to sintering. Subsequently, the sintered aluminium film is etched so as to form cathode electrodes 3, a gate electrode 4 and a control electrode 5 as shown.

The advantages of these constructions of the present invention will now be explained.

The reduction of gate current is discussed first. A GTO of the present invention has the so-called gate amplifying structure, i.e. the auxiliary thyristor in the B region is first turned on by a control signal from the control electrode 5. Subsequently, the load current flowing through the auxiliary thyristor is led through the gate electrode 4 to the main thyristor in the A region as a triggering current for turning on the main thyristor. Since only the auxiliary thyristor in the B region is triggered by the control signal, the control signal required to fire the GTO, i.e. the so-called gate current $I_{GT}$, is greatly decreased compared with that of the GTO of Fig. 1. For example, the GTO of Fig. 1 requires a gate current of 1A, but the gate current of the GTO of Fig. 5 is 0.1A.

As has been described previously, in order to prevent a GTO from being turned off naturally, it is required to supply a constant gate current while the GTO is in the conductive state. However, in the GTO's of the present invention, the main thyristor in the A region cannot be naturally turned off, so long as the auxiliary thyristor in the B region is in the conductive state. Thus, the intensity of the constant gate current can be reduced, and the gate power consumed by the gate current can be decreased to one hundredth of that of the conventional GTO.

Secondly, the improvement of the firing characteristic in the present invention will be discussed. In the auxiliary thyristor formed in the B region, the emitter-base junction on the anode side is not short-circuited. Thus, as the transistor made up of the $p_E$, $n_B$ and $p_B$ layers in the B region, has a large current amplification factor $\alpha_{pnp}$, the auxiliary thyristor is readily fired by a small gate current $I_{GT}$.

Next is described the prevention of malfunctioning which may take place when turning off a GTO. In order to improve the firing characteristic of a GTO, it is required that the width of the emitter-base junction $J_4$ is made large, so that this junction $J_4$ is slightly short-circuited by the gate electrode 4, but this short-circuit cannot be made too small for the following reasons: the above structure has a large short-circuit resistance between the control electrode 5 and the gate electrode 4 bypassing the junction $J_4$. As a result, when the GTO is turned off, the gate current for turning off the GTO flows through the $p_B$ layer, and thus a large voltage drop is generated in the $p_B$ layer. Since the above voltage drop is proportional to the gate current $I_{GT}$ and is varied in accordance with the turn-off condition, in some cases, a gate voltage greater than the breakdown voltage between the cathode electrode 3 and the gate electrode 4 in the A region is applied to the GTO, and the GTO breaks down. Furthermore, if the junction $J_4$ is only slightly short-circuited, when for example a small forward noise voltage is applied between the control electrode 5 and the cathode electrode 3 immediately after the GTO has been turned off, the GTO is again turned on and therefore fails to be turned off.

For these reasons, it is preferable to short-circuit the junction $J_4$ of the auxiliary thyristor to a greater degree. In such a case, the construction according to the present invention in which the p-type emitter-base junction in the B region is not short-circuited, is effective in reducing the gate current $I_{GT}$ and the holding current $I_H$ of the auxiliary thyristor. It has been found experimentally that a short-circuit resistance of 0.1 to 0.5 $\Omega$ in the junction $J_4$ is preferable. In such a case, a GTO of a rated current of 100A required only a current of 0.1 to 0.2A as the constant gate current, and moreover no malfunction took place when the GTO was turned off. In contrast, a conventional GTO of the same rated current required a current of 2A as the constant gate current.

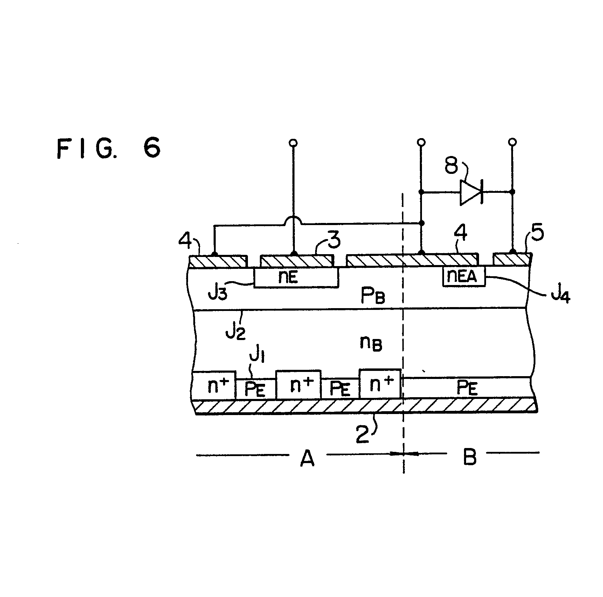

The embodiment shown in Fig. 6 includes a diode 8 between the gate electrode 4 and the control electrode 5, with the result that the greater part of the gate current for turning off the GTO passes through the diode 8, and only a small part thereof flows through the semiconductor substrate, namely the $p_B$ layer of the substrate. Accordingly, the voltage drop in the $p_B$ layer can be reduced to the level of the forward voltage drop of the diode 8. Thus, it becomes possible to solve the problem described above in connection with the prevention of malfunction in turning off a GTO.

In these embodiments, the GTO has a four-layer structure of p-n-p-n in which a p-type layer, an n-type layer, a p-type layer and an n-type layer are stacked in the order described from the anode side to the cathode side.

However, a GTO according to the present invention which includes the alternative four-layer structure of n-p-n-p, can produce the same effects.

Thus by the present invention, there can be provided a GTO which can maintain its conductive state with a small gate current and thus has low control power consumption. The p-type emitter-base junction of the main thyristor can be short-circuited to a large degree by means of the auxiliary thyristor which has a small gate current, and therefore it is possible to obtain a GTO having an excellent turn-off characteristic.

## Claims

1. A gate turn-off thyristor comprising:

a semiconductor substrate (1) including a first semiconductor region of a first conductivity type, a second semiconductor region of a second conductivity type, a third semiconductor region of the first conductivity type, and a fourth semiconductor region of the second conductivity type, the first, second, third and fourth semiconductor regions being stacked in the order described to form a layered structure, the first, second, third and fourth semiconductor regions making up a main thyristor;

a first main electrode (2) disposed in low resistance contact with the first and second semiconductor regions of the main thyristor, the first and second semiconductor regions of the main thyristor being short-circuited by the first main electrode at a large number of positions;

a second main electrode (3) disposed in low resistance contact with the fourth semiconductor region; and

a control electrode (5) disposed in low resistance contact with the third semiconductor region; characterised in that

the semiconductor substrate (1) has a fifth semiconductor region of the second conductivity type adjacent to the third semiconductor region and spaced apart from the fourth semiconductor region, the first, second, third and fifth semiconductor regions making up an auxiliary thyristor;

the first main electrode (2) short circuits the first and second semiconductor regions at the boundary between the main thyristor and the auxiliary thyristor, the first main electrode (2) not being in contact with the second semiconductor region of the auxiliary thyristor so that the first and second regions of the auxiliary thyristor are not short circuited by the first main electrode (2); and

an auxiliary electrode (4) is disposed in low resistance contact with the third and fifth semiconductor regions to short circuit the third and fifth semiconductor regions, and the auxiliary electrode (4) surrounds the second main electrode (3), thereby to prevent the auxiliary thyristor turning on during turn-off of the main thyristor.

2. A thyristor according to claim 1 wherein said first and second regions of said main thyristor and said first regions of said auxiliary thyristor regions are exposed at a first principal surface of said substrate and said third region and said fifth are exposed at a second principal surface of said single semiconductor substrate.

3. A thyristor according to claim 1 or claim 2 wherein said fourth region of said main thyristor is divided into a plurality of sub-regions.

4. A thyristor according to any one of the preceding claims wherein said first and second regions of said main thyristor are electrically short-circuited via said first main electrode (2), at portions of said first principal surface which lie in the orthogonal projection of the area of each sub-region of said fourth region of said main thyristor onto said first principal surface.

5. A thyristor according to any one of the preceding claims wherein the short-circuit resistance formed between said third region of said main thyristor and said fifth region of said auxiliary thyristor by said auxiliary electrode is in the range 0.1 to $0.5\Omega$.

6. A thyristor according to any one of the preceding claims wherein a diode (8) is connected between said control electrode and said auxiliary electrode so that the forward current of said diode flows from said auxiliary electrode toward said control electrode through said diode.

7. A thyristor according to any one of the preceding claims wherein said first conductivity type is p-type conductivity and said second conductivity type is n-type conductivity.

8. A thyristor according to any one of claims 1 to 6 wherein said first conductivity type is n-type conductivity and said second conductivity type is p-type conductivity.

## Patentansprüche

1. Gategesteuerter Abschaltthyristor mit

einem einen ersten Halbleiterbereich eines ersten Leitfähigfähigkeitstyps, einen zweiten Halbleiterbereich eines zweiten Leitfähigkeitstyps, einen dritten Halbleiterbereich des ersten Leitfähigkeitstyps und einen vierten Halbleiterbereich des zweiten Leitfähigkeitstyps aufweisenden Halbleitersubstrat (1), wobei der erste, zweite, dritte und vierte Halbleiterbereich in der angegebenen Reihenfolge zur Bildung einer Schichtstruktur übereinander angeordnet sind und der erste, zweite, dritte und vierte Halbleiterbereich einen Hauptthyristor bilden;

einer in niederohmigem Kontakt mit dem ersten und zweiten Halbleiterbereich des Hauptthyristors angeordneten ersten Hauptelektrode (2), wobei der erste und zweite Halbleiterbereich des Hauptthyristors durch die erste Hauptelektrode an einer großen Anzahl von Stellen kurzgeschlossen sind;

einer in niederohmigem Kontakt mit dem vierten Halbleiterbereich angeordneten zweiten Hauptelektrode (3), und einer in niederohmigem Kontakt mit dem dritten Halbleiterbereich angeordneten Steuerelektrode (5); dadurch gekennzeichnet, daß das Halbleitersubstrat (1) einen an den dritten Halbleiterbereich angrenzenden und von dem vierten Halbleiterbereich beabstandeten fünften Halbleiterbereich des zweiten Leitfähigkeitstyps aufweist, wobei der erste, zweite, dritte und fünfte Halbleiterbereich einen Hilfsthyristor bilden;

die erste Hauptelektrode (2) den ersten und den zweiten Halbleiterbereich an der Grenzfläche zwischen dem Hauptthyristor und dem Hilfsthyristor kurzschließt, wobei die erste Hauptelektrode (2) mit dem zweiten Halbleiterbereich des Hilfsthyristor nicht in Kontakt steht, so daß der erste und der zweite Bereich des Hilfsthyristors durch die erste Hauptelektrode (2) nicht kurzgeschlossen sind; und

eine Hilfselektrode (4) in niederohmigem Kontakt mit dem dritten und dem fünften Halbleiterbereich angeordnet ist, um den dritten und fünften Halbleiterbereich kurzzuschließen, und die Hilfselektrode (4) die zweite Hauptelektrode (3) umgibt, um dadurch eine Einschaltung des Hilfsthyristors während einer Ausschaltung des Hauptthyristors zu verhindern.

2. Thyristor nach Anspruch 1, bei dem die ersten und zweiten Bereich des Hauptthyristors und die ersten Bereich der Hilfsthyristorbereiche an einer ersten Hauptoberfläche des Substrats freiliegen und der dritte und fünfte Bereich an einer zweiten Hauptoberfläche dieses einzigen Halbleitersubstrats freiliegen.

3. Thyristor nach Anspruch 1 oder 2, bei dem der vierte Bereich des Hauptthyristors in eine Vielzahl von Unterbereichen unterteilt ist.

4. Thyristor nach einem der vorhergehenden Ansprüche, bei dem der erste und zweite Bereich des Hauptthyristors vermittels der ersten Hauptelektrode (2) in Bezirken der ersten Hauptoberfläche elektrisch kurzgeschlossen sind, die in der orthogonalen Projektion des Gebietes jedes Unterbereiches des vierten Bereichs des Hauptthyristors auf die erste Hauptoberfläche liegen.

5. Thyristor nach einem der vorhergehenden Ansprüche, bei dem der durch die Hilfselektrode zwischen dem dritten Bereich des Hauptthyristors und dem fünften Bereich des Hilfsthyristors gebildete Kurzschlußwiderstand in dem Bereich von 0,1 bis 0,5 $\Omega$ liegt.

6. Thyristor nach einem der vorhergehenden Ansprüche, bei dem zwischen die Steuerelektrode und die Hilfselektrode eine Diode (8) derart geschaltet ist, daß der Vorwärtsstrom der Diode durch die Diode von der Hilfselektrode zu der Steuerelektrode fließt.

7. Thyristor nach einem der vorhergehenden Ansprüche, bei dem der ersten Leitfähigkeitstyp eine p-Leitfähigkeit und der zweiten Leitfähigkeitstyp eine n-Leitfähigkeit ist.

8. Thyristor nach einem der Ansprüche 1 bis 6, bei dem der ersten Leitfähigkeitstyp eine n-Leitfähigkeit und der zweite Leitfähigkeitstyp eine p-Leitfähigkeit ist.

**Revendications**

1. Thyristor à grille de commande comprenant:

un substrat semi-conducteur (1) comportant une première région semi-conductrice d'un premier type de conductivité, une deuxième région semi-conductrice d'un deuxième type de conductivité, une troisième région semi-conductrice du premier type de conductivité et une quatrième région semi-conductrice du deuxième type de conductivité, les première, deuxième, troisième et quatrième régions semi-conductrices étant empilées dans l'ordre indiqué de façon à former une structure en couches, les première, deuxième, troisième et quatrième régions conductrices constituant un thyristor principal;

une première électrode principale (2) disposée en contact de faible résistance avec les première et deuxième régions semi-conductrices du thyristor principal, les première et deuxième régions conductrices du thyristor principal étant mises en court-circuit par la première électrode principale en un grand nombre de positions;

une deuxième électrode principale (3) disposée en contact de faible résistance avec la quatrième région semi-conductrice; et

une électrode de commande (5) disposée en contact de faible résistance avec la troisième région semi-conductrice; caractérisé en ce que

le substrat semi-conducteur (1) possède une cinquième région semi-conductrice du deuxième type de conductivité adjacente à la troisième région semi-conductrice et écartée de la quatrième région semi-conductrice, les première, deuxième, troisième et cinquième régions semi-conductrices constituant un thyristor auxiliaire;

la première électrode principale (2) court-circuite les première et deuxième régions semi-conductrices à la frontière entre le thyristor principal et le thyristor auxiliaire, la première électrode principale (2) n'étant pas en contact avec la deuxième région semi-conductrice du thyristor auxiliaire si bien que les première et deuxième régions du thyristor auxiliaire ne sont pas mises en court-circuit par la première électrode principale (2); et

une électrode auxiliaire (4) est disposée en contact de faible résistance avec les troisième et cinquième régions semi-conductrices de façon à court-circuiter les troisième et cinquième régions semi-conductrices, et l'électrode auxiliaire (4) entoure la deuxième électrode principale (3), si bien que la fermeture du thyristor auxiliaire est empêchée pendant l'ouverture du thyristor principal.

2. Thyristor selon la revendication 1, où lesdites première et deuxième régions dudit thyristor principal et ladite première régions dudit thyristor auxiliaire régions sont exposées à une première surface principale dudit substrat, et ladite troisième région et ladite cinquième sont exposées à une deuxième surface principale dudit substrat semi-conducteur unique.

3. Thyristor selon la revendication 1 ou la revendication 2, où ladite quatrième région dudit thyristor principal est divisée en plusieurs sous-régions.

4. Thyristor selon l'une quelconque des revendications précédentes, où lesdites première et deuxième régions dudit thyristor principal sont mises en court-circuit électrique par l'intermédiaire de ladite première électrode principale (2, en des parties de ladite première surface principale qui sont situées dans la projection orthogonale de l'aire de chaque sous-région de ladite quatrième région dudit thyristor principal sur ladite première surface principale.

5. Thyristor selon l'une quelconque des revendications précédentes, où ladite résistance de court-circuit formée entre ladite troisième région dudit thyristor principal et ladite cinquième région dudit thyristor auxiliaire par ladite électrode auxiliaire est comprise dans l'intervalle de 0,1 à 0,5 ohm.

6. Thyristor selon l'une quelconque des revendications précédentes, où une diode (8) est connectée entre ladite électrode de commande et ladite électrode auxiliaire de façon que le courant direct de ladite diode passe de ladite électrode auxiliaire à ladite électrode de commande via ladite diode.

7. Thyristor selon l'une quelconque des revendications précédentes, où ledit premier type de conductivité est le type p et ledit deuxième type de conductivité est le type n.

8. Thyristor selon l'une quelconque des revendications 1 à 6, où ledit premier type de conductivité est le type n et ledit deuxième type de conductivité est le type p.

FIG. 1

FIG. 2

FIG. 3

1

# FIG. 4

# FIG. 5

FIG. 6